(19) Europäisches Patentamt / European Patent Office / Office européen des brevets

(11) **EP 4 095 896 A1**

(12) **EUROPEAN PATENT APPLICATION**
published in accordance with Art. 153(4) EPC

(43) Date of publication:
**30.11.2022  Bulletin 2022/48**

(21) Application number: **21743761.5**

(22) Date of filing: **22.01.2021**

(51) International Patent Classification (IPC):
*H01L 23/36* (2006.01)   *H01L 23/373* (2006.01)
*C04B 37/02* (2006.01)   *C01B 32/194* (2017.01)
*C01B 32/914* (2017.01)   *C01B 32/921* (2017.01)

(52) Cooperative Patent Classification (CPC):
C01B 32/194; C01B 32/914; C01B 32/921;
C04B 37/02; H01L 23/36; H01L 23/373

(86) International application number:
**PCT/JP2021/002260**

(87) International publication number:
**WO 2021/149802 (29.07.2021 Gazette 2021/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.01.2020  JP 2020009691**
**20.01.2021  JP 2021007345**

(71) Applicant: **Mitsubishi Materials Corporation Tokyo 100-8117 (JP)**

(72) Inventor: **TERASAKI, Nobuyuki Saitama-shi, Saitama 330-8508 (JP)**

(74) Representative: **Hoffmann Eitle Patent- und Rechtsanwälte PartmbB Arabellastraße 30 81925 München (DE)**

(54) **COPPER/GRAPHENE JOINED BODY AND METHOD FOR MANUFACTURING SAME, AND COPPER/GRAPHENE JOINED STRUCTURE**

(57) A copper-graphene bonded body is a copper-graphene bonded body including a copper member made of copper or a copper alloy and a ceramic member made of silicon nitride, the copper member. The copper member and the ceramic member are bonded to each other, between the copper member and the graphene-containing carbonaceous member, an active metal carbide layer containing a carbide of one or more kinds of active metal selected from Ti, Zr, Nb, and Hf is formed on a side of the graphene-containing carbonaceous member, and a Mg solid solution layer having Mg dissolved in a matrix phase of Cu is formed between the active metal carbide layer and the copper member.

FIG. 3

**Description**

TECHNICAL FIELD

The present invention relates to a copper-graphene bonded body having a structure in which a copper member formed of copper or a copper alloy and a graphene-containing carbonaceous member containing a graphene aggregate are bonded and a method for manufacturing the same, and a copper-graphene bonded structure.

Priority is claimed on Japanese Patent Applications No. 2020-009691, filed January 24, 2020, and No. 2021-007345, filed January 20, 2021, the content of which is incorporated herein by reference.

BACKGROUND ART

A graphene-containing carbonaceous member containing a graphene aggregate is particularly suitable for a member constituting a heat dissipation member, a heat conductive member, and the like because it has excellent thermal conductivity.

For example, an insulating layer formed of ceramic is formed on a surface of the graphene-containing carbonaceous member containing a graphene aggregate described above, such that it is possible to use the graphene-containing carbonaceous member as an insulation substrate.

For example, Patent Document 1 discloses an anisotropic heat conduction element which has a structure in which a graphene sheet is laminated along a first direction, and an intermediate member (copper plate) is bonded to an end surface of the structure in a second direction intersecting the first direction, and in which the intermediate member is pressure-bonded to the end surface via an insert material containing at least titanium.

[Citation List]

[Patent Document]

[Patent Document 1]
Japanese Unexamined Patent Application, First Publication No. 2012-238733

SUMMARY OF INVENTION

Technical Problem

Meanwhile, a thermal cycle in the insulation substrate described above may be loaded in a use environment. In particular, recently, the thermal cycle may be used in a harsh environment such as an engine room, and the thermal cycle under severe conditions of a large temperature difference may be loaded.

Here, in Patent Document 1 described above, the intermediate formed of copper and the graphene structure are bonded via the insert material containing titanium. However, the intermediate formed of copper and the graphene structure cannot be firmly bonded according to the bonding conditions, and thus peeling may occur during loading of the thermal cycle under the severe conditions.

The present invention has been made in view of the above-mentioned circumstances, and an object thereof is to provide a copper-graphene bonded body having excellent reliability on a thermal cycle, in which a copper member formed of copper or a copper alloy and a graphene-containing carbonaceous member containing a graphene aggregate are firmly bonded without peeling occurring during loading of the thermal cycle, and a method for manufacturing the same.

Solution to Problem

In order to solve the problem and achieve the object, a copper-graphene bonded body according to the present invention is a copper-graphene bonded body includes a copper member formed of copper or a copper alloy and a graphene-containing carbonaceous member containing a graphene aggregate. The copper-graphene bonded body has a structure in which the copper member and the graphene-containing carbonaceous member are bonded, between the copper member and the graphene-containing carbonaceous member, an active metal carbide layer containing a carbide of one or more kinds of active metal selected from Ti, Zr, Nb, and Hf is formed on a side of the graphene-containing carbonaceous member, and a Mg solid solution layer having Mg dissolved in a matrix phase of Cu is formed between the active metal carbide layer and the copper member.

In the copper-graphene bonded body with this configuration, at the bonding interface between the copper member and the graphene-containing carbonaceous member, the active metal carbide layer is formed on a bonding surface of the graphene-containing carbonaceous member, and the Mg solid solution layer having Mg dissolved in the matrix phase of Cu is formed on a bonding surface side of the copper member.

As a result, since Mg in the Mg solid solution layer sufficiently reacts with the active metal in the active metal carbide layer, and the copper member is firmly bonded to a graphene-containing carbonaceous member via the active metal carbide layer, it is possible to prevent cracks and peeling from occurring at the bonding interface during loading of the thermal cycle. Moreover, the copper-graphene bonded body with this configuration contains copper as a constituent material, and thus has a function of efficiently dissipating heat as a heat spreader in a transition period. Therefore, the copper-graphene bonded body with this configuration can maintain stable heat dissipation characteristics and can realize high reliability while preventing the occurrence of peeling at the bonding interface accompanied by the thermal cycle.

Further, in the copper-graphene bonded body according to the present invention, preferably, a Cu-Mg intermetallic compound phase formed of an intermetallic compound containing Cu and Mg is present in the Mg solid solution layer.

In this case, the Cu-Mg intermetallic compound phase is distributed on a bonding surface side with the active metal carbide layer, which is greatly involved in the bonding, such that it is possible to enhance the strength of the bonding with the active metal carbide layer.

An area ratio B/A is preferably 0.3 or less, where A is an area of a region in the Mg solid solution layer within a distance of 50 $\mu$m from a boundary between the active metal carbonized layer and the Mg solid solution layer toward the copper member, and B is an area of the Cu-Mg intermetallic compound phase.

Further, in the copper-graphene bonded body according to the present invention, preferably, an active metal compound phase formed of an intermetallic compound containing Cu and the active metal is present in the Mg solid solution layer.

In this case, the active metal compound phase is distributed on a bonding surface side with the active metal carbide layer, which is greatly involved in the bonding, such that it is possible to enhance the strength of the bonding with the active metal carbide layer.

Moreover, in the copper-graphene bonded body according to the present invention, preferably, the graphene-containing carbonaceous member contains a graphene aggregate formed by deposition of a single layer or multiple layers of graphene, and flat graphite particles, the flat graphite particles are laminated with the graphene aggregate as a binder so that basal surfaces of the flat graphite particles overlap with one another, and the basal surfaces of the flat graphite particles are oriented in one direction.

In this case, thermal conduction properties of the graphene-containing carbonaceous member can be further improved.

A method for manufacturing a copper-graphene bonded body according to the present invention includes an active metal- and Mg-disposing step of disposing one or more kinds of active metal selected from Ti, Zr, Nb, and Hf, and Mg between the copper member and the graphene-containing carbonaceous member, a laminating step of laminating the copper member and the graphene-containing carbonaceous member via the active metal and Mg, and a bonding step of bonding the copper member and the graphene-containing carbonaceous member laminated via the active metal and Mg by being heat-treated in a vacuum atmosphere, while pressurizing the copper member and the graphene-containing carbonaceous member in a laminating direction. In the active metal- and Mg-disposing step, an amount of the active metal is set within a range of 0.4 $\mu$mol/cm$^2$ or more and 47.0 $\mu$mol/cm$^2$ or less, and an amount of Mg is set within a range of 14 $\mu$mol/cm$^2$ or more and 180 $\mu$mol/cm$^2$ or less.

According to the method for manufacturing a copper-graphene bonded body with this configuration, an amount of the active metal is set within a range of 0.4 $\mu$mol/cm$^2$ or more and 47.0 $\mu$mol/cm$^2$ or less, and an amount of Mg is set within a range of 14 $\mu$mol/cm$^2$ or more and 180 $\mu$mol/cm$^2$ or less, in the active metal- and Mg-disposing step, such that it is possible to sufficiently obtain a liquid phase required for an interfacial reaction. Therefore, the copper member and the graphene-containing carbonaceous member can be reliably bonded.

Here, in the method for manufacturing a copper-graphene bonded body according to the present invention, preferably, the pressurizing load in the bonding step is set within a range of 0.049 MPa or more and 1.96 MPa or less, and the heating temperature in the bonding step is set within a range of 700°C or higher and 950°C or lower.

In this case, in the bonding step, the pressurizing load is set within a range of 0.049 MPa or more and 1.96 MPa or less, and the heating temperature is set within range of 700°C or higher and 950°C or lower, such that it is possible to hold a liquid phase required for an interfacial reaction, and promote a uniform interfacial reaction.

A copper-graphene bonded structure according to the present invention is a copper-graphene bonded structure having a structure in which a copper member formed of copper or a copper alloy and a graphene-containing carbonaceous member containing a graphene aggregate are bonded, in which between the copper member and the graphene-containing carbonaceous member, an active metal carbide layer containing a carbide of one or more kinds of active metal selected from Ti, Zr, Nb, and Hf is formed on a side of the graphene-containing carbonaceous member, and a Mg solid solution layer having Mg dissolved in a matrix phase of Cu is formed between the active metal carbide layer and the copper member.

In the copper-graphene bonded structure with this configuration, at the bonding interface between the copper member and the graphene-containing carbonaceous member, the active metal carbide layer is formed on a bonding surface of the graphene-containing carbonaceous member, and the Mg solid solution layer having Mg dissolved in the matrix phase of Cu is formed on a bonding surface side of the copper member. As a result, since Mg in the Mg solid solution layer sufficiently reacts with the active metal in the active metal carbide layer, and the copper member is firmly bonded to a graphene-containing carbonaceous member via the active metal carbide layer, it is possible to prevent cracks and peeling from occurring at the bonding interface during loading of the thermal cycle. Moreover, the copper-graphene bonded structure with this configuration contains copper as a constituent material, and thus has a function of efficiently dissipating heat as a heat spreader in a transition period. Therefore, the copper-graphene bonded structure with this configuration can maintain stable heat dissipation characteristics and can realize high reliability while preventing the occurrence of peeling at the bonding interface accompanied by the thermal cycle.

Advantageous Effects of Invention

According to the present invention, it is possible to provide a copper-graphene bonded body and a method for manufacturing the same, and a copper-graphene bonded structure, the copper-graphene bonded body having excellent reliability on a thermal cycle, in which a copper member formed of copper or a copper alloy and a graphene-containing carbonaceous member containing a graphene aggregate are firmly bonded without peeling occurring during loading of the thermal cycle.

BRIEF DESCRIPTION OF DRAWINGS

Fig. 1 is a schematic explanatory view of a power module using a copper-graphene bonded body (insulation substrate) according to an embodiment of the present invention.
Fig. 2 is a schematic explanatory view of the copper-graphene bonded body (insulation substrate) according to the embodiment of the present invention.
Fig. 3 is a schematic view of a bonding interface between a copper member and a graphene-containing carbonaceous member of the copper-graphene bonded body (insulation substrate) according to the embodiment of the present invention.
Fig. 4 is a flowchart representing an example of a method for manufacturing a copper-graphene bonded body (insulation substrate) according to the embodiment of the present invention.

DESCRIPTION OF EMBODIMENTS

Hereinafter, embodiments of the present invention will be described with reference to the accompanying drawings. Each of the embodiments shown below provides specific explanation to better understand the concept of the present invention, although the present invention is not limited unless otherwise specified. In the drawings used in the following description, in order to make the characteristics of the present invention easy to understand, the main parts may be shown in an enlarged manner, and dimensional ratios and the like of the respective constituent elements are not necessarily the same as the actual ratios and the like.

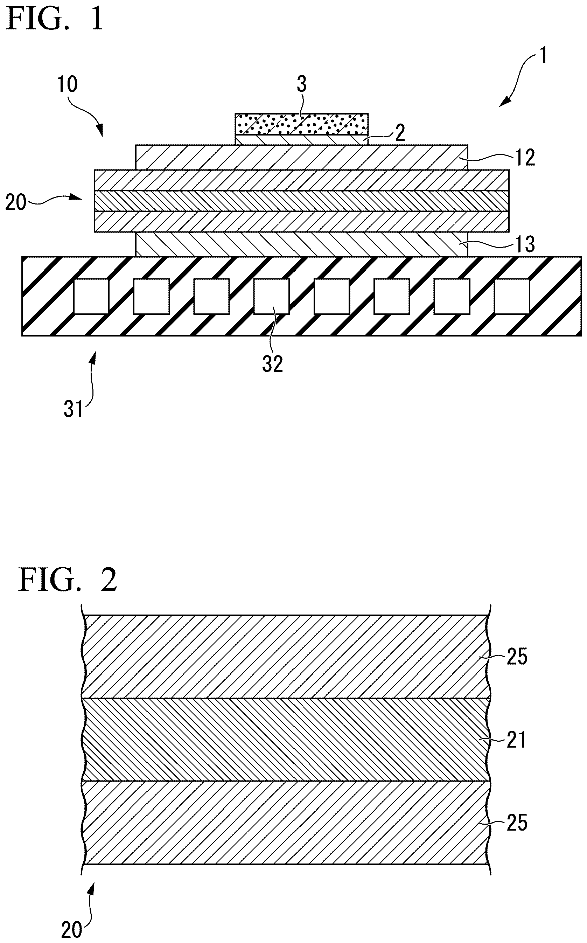

First, a copper-graphene bonded body (copper-graphene bonded structure) according to an embodiment of the present invention will be described with reference to Figs. 1 to 4.

The copper-graphene bonded body in the present embodiment is an insulation substrate 20 having a structure in which a copper member formed of copper and a copper alloy and a graphene-containing carbonaceous member containing a graphene aggregate are bonded.

First, a power module using the copper-graphene bonded body (insulation substrate 20) according to the present embodiment will be described.

A power module 1 represented in Fig. 1 includes an insulating circuit substrate 10, a semiconductor element 3 bonded to one surface side (upper side in Fig. 1) of the insulating circuit substrate 10 via a solder layer 2, and a heat sink 31 disposed on the other surface side (lower side in Fig. 1) of the insulating circuit substrate 10.

The insulating circuit substrate 10 includes an insulating layer (insulation substrate 20), a circuit layer 12 disposed on one surface (upper surface in Fig. 1) of the insulating layer, and a metal layer 13 disposed on the other surface (lower surface in Fig. 1) of the insulating layer.

The insulating layer prevents electrical connection between the circuit layer 12 and the metal layer 13, and is composed of the insulation substrate 20 according to the present embodiment.

The circuit layer 12 is formed by bonding a metal plate having excellent conductivity to one surface of the insulating layer (insulation substrate 20). In the present embodiment, a copper plate formed of copper or a copper alloy, specifically, a rolled plate of oxygen-free copper is used as the metal plate constituting the circuit layer 12. The circuit layer 12 has a circuit pattern formed thereon, and one surface (upper surface in Fig. 1) thereof is a mounting surface on which the semiconductor element 3 is mounted.

In addition, a thickness of the metal plate (copper plate) serving as the circuit layer 12 is set within a range of 0.1 mm or more and 1.0 mm or less, and in the present embodiment, the thickness is set to 0.6 mm.

A method for bonding the metal plate (copper plate) serving as the circuit layer 12 and the insulation substrate 20 is not particularly limited, and the metal plate (copper plate) serving as the circuit layer 12 and the insulation substrate 20 can be bonded using an active metal brazing material or the like.

The metal layer 13 is formed by bonding a metal plate having excellent thermal conductivity to the other surface of the insulating layer (insulation substrate 20). In the present embodiment, a copper plate formed of copper or a copper alloy, specifically, a rolled plate of oxygen-free copper is used as the metal plate constituting the metal layer 13.

In addition, a thickness of the metal plate (copper plate) serving as the metal layer 13 is set within a range of 0.1 mm or more and 1.0 mm or less, and in the present embodiment, the thickness is set to 0.6 mm.

A method for bonding the metal plate (copper plate) serving as the metal layer 13 and the insulation substrate 20 is not particularly limited, and the metal plate (copper plate) serving as the metal layer 13 and the insulation substrate 20 can be bonded using an active metal brazing material or the like.

The heat sink 31 is provided to cool the above-described insulating circuit substrate 10, and has a structure in which a plurality of flowing paths 32 for flowing a cooling medium (for example, cooling water) are provided.

The heat sink 31 is preferably formed of a material having good thermal conductivity, such as aluminum or an aluminum alloy and copper or a copper alloy, and in the present embodiment, the heat sink 31 may be formed of 2N aluminum having a purity of 99 mass% or more.

In the present embodiment, the metal layer 13 of the insulating circuit substrate 10 and the heat sink 31 are bonded by a solid-phase diffusion bonding method.

The semiconductor element 3 is formed using, for example, a semiconductor material such as Si or SiC. The semiconductor element 3 is mounted on the circuit layer 12 via, for example, a solder layer 2 formed of a solder material based on Sn-Ag, Sn-In, or Sn-Ag-Cu.

As represented in Fig. 2, the insulation substrate 20 according to the present embodiment constituting the insulating layer has a structure in which a copper plate 21 composed of a copper member formed of copper or a copper alloy, and a carbon plate 25 composed of a graphene-containing carbonaceous member containing a graphene aggregate are laminated. The copper plates 21 are each bonded to both main surfaces of the carbon plate 25.

Here, as the insulation substrate 20, a substrate in which a carbon plate 25, a copper plate 21, and a carbon plate 25 are laminated in this order is described by way of example. However, the copper plate 21 and the carbon plate 25 may be laminated alternately, and the number of laminated layers is not limited. An outermost layer (end portion) of the insulation substrate 20 in a laminating direction may be the carbon plate 25 as in the present embodiment, or may be the copper plate 21.

The graphene-containing carbonaceous member constituting the carbon plate 25 contains a graphene aggregate obtained by deposition of a single layer or multiple layers of graphene, and flat graphite particles, and preferably has a structure in which the flat graphite particles are laminated with the graphene aggregate as a binder so that the basal surfaces of the flat graphite particles overlap with one another. The basal surfaces of the flat graphite particles preferably have a structure in which they are oriented in one direction.

The flat graphite particles have a basal surface on which a carbon hexagonal net surface appears and an edge surface on which an end portion of the carbon hexagonal net surface appears. As the flat graphite particles, scaly graphite, scale-like graphite, earthy graphite, flaky graphite, kish graphite, pyrolytic graphite, highly-oriented pyrolytic graphite, and the like can be used.

Here, an average particle size of the graphite particles viewed from the basal surface is preferably within a range of 10 $\mu$m or more and 1,000 $\mu$m or less, and more preferably within a range of 50 $\mu$m or more and 800 $\mu$m or less. The average particle size of the graphite particles is set within the above range, thereby improving thermal conductivity.

Furthermore, a thickness of the graphite particles is preferably within a range of 1 $\mu$m or more and 50 $\mu$m or less, and more preferably within a range of 1 $\mu$m or more and 20 $\mu$m or less. The thickness of the graphite particles is set within the above range, thereby properly adjusting orientation of the graphite particles.

In addition, by setting the thickness of the graphite particles within a range of 1/1,000 to 1/2 of the particle size viewed from the basal surface, excellent thermal conductivity is obtained and the orientation of the graphite particles is properly adjusted.

The graphene aggregate is a deposit of a single layer or multiple layers of graphene, and the number of multiple layers of graphene laminated is, for example, 100 layers or less, and preferably 50 layers or less. The graphene aggregate can be produced by, for example, dripping a graphene dispersion obtained by dispersing a single layer or multiple layers of graphene in a solvent containing a lower alcohol or water onto filter paper, and depositing the graphene while separating the solvent therefrom.

Here, an average particle size of the graphene aggregate is preferably within a range of 1 $\mu$m or more and 1,000 $\mu$m or less. The average particle size of the graphene aggregate is set within the above range, thereby improving thermal conductivity.

Furthermore, a thickness of the graphene aggregate is preferably within a range of 0.05 $\mu$m or more and less than 50 $\mu$m. The thickness of the graphene aggregate is set within the above range, thereby securing strength of the carbonaceous member.

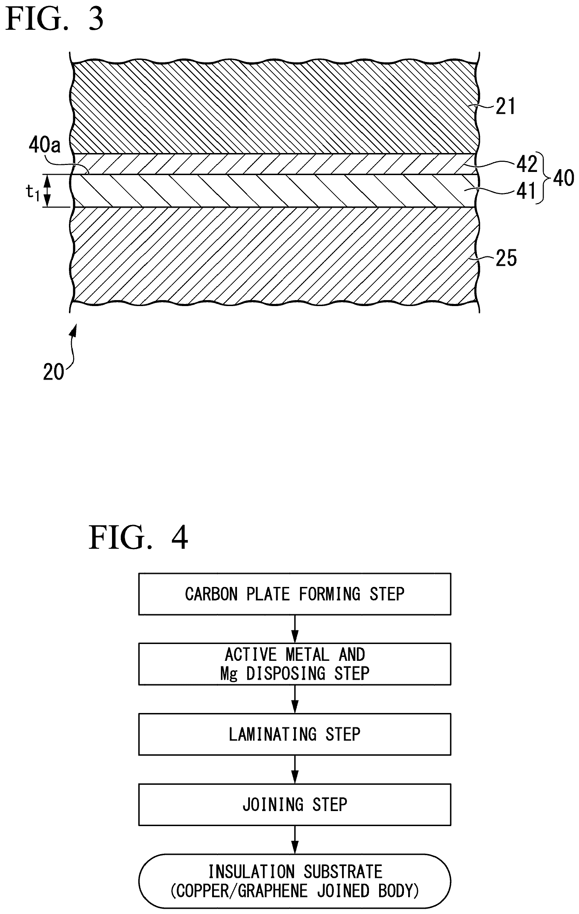

Here, Fig. 3 represents a schematic diagram of a bonding interface between the copper plate 21 composed of a copper member formed of copper or a copper alloy and the carbon plate 25 formed of the graphene-containing carbonaceous member. As represented in Fig. 3, an active metal carbide layer 41 containing one or two kinds of active metal carbides is formed on a bonding surface with the carbon plate 25 between the copper plate 21 formed of the copper member and the carbon plate 25 formed of the graphene-containing carbonaceous member (bonding interface 40).

Further, the copper plate 21 contains single metals such as Mg and Cu, intermetallic compounds (IMCs) such as Cu-Mg and Cu-Ti, and the like, and particularly, a Mg solid solution layer 42 having Mg dissolved in a matrix phase of Cu is formed between the copper plate 21 and the active metal carbide layer 41 at the bonding interface 40. In the Mg solid solution layer 42, a Cu-Mg intermetallic compound phase formed of an intermetallic compound containing Cu and Mg may be present, or an active metal compound phase formed of an intermetallic compound containing Cu and an active metal may be present.

The Cu-Mg intermetallic compound phase is composed of a $Cu_2Mg$ phase and/or a $CuMg2$ phase.

An area ratio B/A is preferably 0.3 or less, more preferably 0.25 or less, and most preferably 0.15 or less, where A ($\mu$m$^2$) is an area of a region in the Mg solid solution layer 42 within a distance of 50 $\mu$m from a boundary surface 40a between the active metal carbide layer 41 and the Mg solid solution layer 42 toward the copper member, and B ($\mu$m$^2$) is an area of the Cu-Mg intermetallic compound phase in the same region, in a cross section of the copper plate 21 formed of the copper member and the carbon plate 25 formed of the graphene-containing carbonaceous member along the laminating direction.

The Mg solid solution layer 42 may not contain the Cu-Mg intermetallic compound phase, in other words, the ratio B/A may be 0.

The active metal carbide layer 41 is formed by reacting the active metal contained in a bonding material interposed between the copper plate 21 and the carbon plate 25 during bonding with carbon contained in the carbon plate 25.

Examples of the active metal constituting the active metal carbide layer 41 may include one or more kinds selected from Ti, Zr, Hf, and Nb. In the present embodiment, the active metal is composed of Ti, and the active metal carbide layer 41 is composed of titanium carbide (Ti-C).

Here, if a thickness t1 of the active metal carbide layer 41 is less than 0.05 $\mu$m, the reaction between the active metal and carbon may not become sufficient, and a bonding strength between the copper plate 21 and the carbon plate 25 via the active metal carbide layer 41 may not become sufficient. On the other hand, if the thickness t1 of the active metal carbide layer 41 exceeds 1.5 $\mu$m, cracks may occur in the active metal carbide layer 41 during loading of the thermal cycle.

Therefore, in the present embodiment, the thickness t1 of the active metal carbide layer 41 is preferably set within a range of 0.05 $\mu$m or more and 1.5 $\mu$m or less.

A lower limit of the thickness t1 of the active metal carbide layer 41 is more preferably 0.1 $\mu$m or more, and still more preferably 0.25 $\mu$m or more. On the other hand, an upper limit of the thickness t1 of the active metal carbide layer 41 is more preferably 1.2 $\mu$m or less, and still more preferably 1.0 $\mu$m or less.

Next, a method for manufacturing a copper-graphene bonded body (insulation substrate 20) according to the present embodiment will be described with reference to a flowchart represented in Fig. 4.

(Carbon Plate-Forming Step S01)

First, the flat graphite particles and the graphene aggregate described above are weighed so as to obtain a predetermined blending ratio, and are mixed by an existing mixing device such as a ball mill.

The obtained mixture is filled in a mold having a predetermined shape and pressurized, thereby obtaining a molded body. Heating may be performed during pressurization.

The obtained molded body is then cut out to obtain a carbon plate 25.

A pressure during molding is preferably set within a range of 20 MPa or more and 1,000 MPa or less, and more preferably set within a range of 100 MPa or more and 300 MPa or less.

In addition, a temperature during molding is preferably set within a range of 50°C or higher and 300°C or lower.

Moreover, a pressurizing time is preferably set within a range of 0.5 minutes or longer and 10 minutes or shorter.

(Active Metal- and Mg-Disposing Step S02)

Next, the copper plate 21 formed of copper or a copper alloy is prepared, and one or more kinds of active metal selected from Ti, Zr, Nb, and Hf, Cu, and Mg can be disposed between the copper plate 21 and the carbon plate 25 as a bonding material by allowing a bonding surface of the copper plate 21 and the bonding surface of the carbon plate 25 obtained in the previous step to face each other.

Here, as the bonding material, a material containing Mg, Cu, and an active metal (Ti in the present embodiment) is used.

The bonding material may be in the form of a paste or in the form of a foil. In addition, a material obtained by laminating, for example, a Cu-Mg alloy and the active metal may be used. The bonding material may further contain inevitable impurities.

The active metal, Cu, and Mg can be disposed by sputtering, (co-)evaporation, foil material, or application of paste (active metal and hydride of Mg are also available).

In the active metal- and Mg-disposing step S02, an amount of the active metal disposed is preferably set within a range of 0.4 $\mu$mol/cm$^2$ or more and 47.0 $\mu$mol/cm$^2$ or less, and an amount of Mg is preferably set within a range of 14 $\mu$mol/cm$^2$ or more and 180 $\mu$mol/cm$^2$ or less. Moreover, Cu can be disposed in an amount within a range of 4 $\mu$mol/cm$^2$ or more and 350 $\mu$mol/cm$^2$ or less.

(Laminating Step S03)

Next, the carbon plate 25 is laminated (bonded) to each of both main surfaces of the copper plate 21 described above via a bonding material.

(Bonding Step S04)

Next, the copper plates 21 and the carbon plate 25 laminated via the bonding material are pressurized in the laminating direction, heated, and then cooled to bond the copper plates 21 and the carbon plate 25.

In this case, a heating temperature is preferably set within a range of 700°C or higher and 950°C or lower. In addition, a holding time at the heating temperature is preferably set within a range of 10 minutes or longer and 180 minutes or shorter. Moreover, a pressurizing pressure is preferably set within a range of 0.049 MPa or more and 1.96 MPa or less. In addition, an atmosphere during bonding is preferably a nonoxidative atmosphere.

Through the bonding step S04, the active metal contained in the bonding material (Ti in the present embodiment) reacts with carbon contained in the carbon plate 25, thereby forming an active metal carbide layer 41 on the bonding surface of the carbon plate 25.

Cu, Mg, and a part of the active metal contained in the bonding material are absorbed into the copper plate 21, and Cu and Mg contained in the bonding material react with each other, thereby forming a Mg solid solution layer 42 having Mg dissolved in a matrix phase of Cu between the copper plate 21 and the active metal carbide layer 41. The Mg solid solution layer 42 may contain an active metal compound phase formed of an intermetallic compound containing Cu and the active metal.

Through the above steps, a copper-graphene bonded body (insulation substrate 20) according to the present embodiment is manufactured.

Hitherto, the insulation substrate 20 which is composed of the copper member 21 and the graphene-containing carbonaceous members 25 with the copper member 21 interposed therebetween has been described by way of example. However, the copper-graphene bonded body (copper-graphene bonded structure) according to the present embodiment may be a bonded body in which copper and graphene are bonded (bonded body including a bonded part). For example, the graphene-containing carbonaceous member may be a copper-graphene-ceramic bonded body (copper-graphene-ceramic bonded structure) obtained by further bonding a ceramic member, or may be a ceramicgraphene-copper-graphene-ceramic bonded body (ceramic-graphene-copper-graphene-ceramic bonded structure). In this case, as the bonding material between a graphene member and the ceramic member, a material containing Cu and an active metal-based element such as Ag, Mg, or P is used. As the ceramic member (ceramic plate), a member containing oxides such as $Al_2O_3$ and Zr-added $Al_2O_3$, nitrides such as AlN and $Si_3N_4$, and SiAlON is used.

According to the copper-graphene bonded body (insulation substrate 20) of the present embodiment configured as described above, at the bonding interface between the copper member (copper plate 21) and the graphene-containing carbonaceous member (carbon plate 25), the active metal carbide layer 41 is formed on a bonding surface of the graphene-containing carbonaceous member, and the Mg solid solution layer 42 having Mg dissolved in the matrix phase of Cu is formed on a bonding surface side of the copper member. As a result, since Mg in the Mg solid solution layer 42 sufficiently reacts with the active metal in the active metal carbide layer 41, and the copper member is firmly bonded to the graphene-containing carbonaceous member via the active metal carbide layer 41, it is possible to prevent cracks and peeling from occurring at the bonding interface during loading of the thermal cycle. Moreover, the copper-graphene bonded body according to the present embodiment contains copper as a constituent material thereof, and thus has a function of efficiently dissipating heat as a heat spreader in a transition period. Therefore, the copper-graphene bonded body according to the present embodiment can maintain stable heat dissipation characteristics and can realize high reliability while preventing the occurrence of peeling at the bonding interface 40 accompanied by the thermal cycle.

Alternatively, in the copper-graphene bonded body according to the present embodiment, preferably, an active metal compound phase formed of an intermetallic compound containing Cu and the active metal is present in the Mg solid solution layer. In this case, the active metal compound phase is distributed on a bonding surface side with the active metal carbide layer, which is greatly involved in the bonding, such that it is possible to enhance the strength of the bonding with the active metal carbide layer.

Moreover, in the copper-graphene bonded body according to the present embodiment, the graphene-containing carbonaceous member contains a graphene aggregate formed by deposition of a single layer or multiple layers of graphene, and flat graphite particles, and preferably has a structure in which the flat graphite particles are laminated with the graphene aggregate as a binder so that basal surfaces of the flat graphite particles overlap with one another, and the basal surfaces of the flat graphite particles are oriented in one direction. In this case, thermal conduction properties of the graphene-containing carbonaceous member can be further improved.

The embodiments of the present invention have been described as above, but the present invention is not limited thereto, and can be appropriately modified without departing from the technical ideas of the invention.

For example, in the present embodiment, the configuration in which a semiconductor element (power semiconductor element) is mounted on the circuit layer of the insulating circuit substrate to constitute a power module has been described, but the present invention is not limited thereto. For example, an LED element may be mounted on the insulating circuit substrate to constitute an LED module, or a thermoelectric element may be mounted on the circuit layer of the insulating circuit substrate to constitute a thermoelectric module.

Further, it has been described in the present embodiment that the insulation substrate 20 according to the present embodiment is applied as an insulating layer of the insulating circuit substrate 10 as represented in Fig. 1. However, the present invention is not limited thereto, and there is no particular limitation on a method for using the copper-graphene bonded body according to the present invention.

[Examples]

Confirmation experiments (Inventive Examples 1 to 8 and 11 to 19, and Comparative Examples 1 to 3) performed to confirm the effectiveness of the present invention will be described.

As disclosed in the present embodiment, flat graphite particles and a graphene aggregate were blended at a predetermined blending ratio and mixed. The mixture was heated under pressure and molded to obtain a molded body having a structure in which the flat graphite particles were laminated with the graphene aggregate as a binder so that the basal surfaces of the flat graphite particles overlapped with one another. The obtained molded body was cut out to obtain a carbon plate (40 mm × 40 mm × thickness 1.5 mm).

Mg and an active metal were disposed on one surface of the carbon plate at amounts shown in Tables 1 and 2, a copper plate (37 mm × 37 mm × thickness 0.6 mm) was laminated on the disposed Mg and active metal, and the carbon plate and the copper plate were bonded under conditions shown in Tables 1 and 2.

The Mg and active metal were disposed using co-evaporation.

Here, a bonding interface between the carbon plate and the copper plate was observed, and confirmation was made as to whether or not an active metal carbide layer was present, whether or not an active metal compound phase was present, and whether or not a Mg solid solution layer was present.

(Whether or Not Active Metal Carbide Layer is Present)

The bonding interface between the copper plate and the carbon plate in a cross section of the obtained bonded body in the laminating direction was observed under conditions of a magnification from 20,000 times to 120,000 times and an accelerating voltage of 200 kV using a scanning transmission electron microscope (Titan ChemiSTEM (with EDS detector) manufactured by FEI). Mapping was performed using energy dispersive X-ray analysis (NSS7 manufactured by Thermo Fisher Scientific), an electron diffraction pattern was obtained by irradiating a region where the active metal and C overlapped with each other with an electron beam narrowed to about 1 nm (nano beam diffraction (NBD) method), and when the electron diffraction pattern was intermetallic compounds of the active metal and C, the active metal carbide layer was defined as "present".

(Whether or Not Cu-Mg Intermetallic Compound Phase is Present and Area Ratio)

The bonding interface between the copper plate and the carbon plate in the cross section of the obtained bonded body in the laminating direction was observed under conditions of a magnification of 2,000 times and an accelerating voltage of 15 kV using an electron beam microanalyzer (JXA-8539F manufactured by JEOL Ltd.), and elemental mapping of Mg in a region including the bonding interface (400 $\mu$m × 600 $\mu$m, hereinafter, referred to as an observation region) was obtained. Confirmation was made as to whether or not the Cu-Mg intermetallic compound phase was present in a region, as a Cu-Mg intermetallic compound phase, satisfying a Cu concentration of 5 atom% or more and a Mg concentration of 30 atoms or more and 70 atom% or less from a 5-point average of quantitative analysis in the region confirmed by the presence of Mg. The concentration here is a concentration when a total amount of Cu and Mg is 100 atom%.

In addition, in the bonded body of Inventive Examples 11 to 19, an area ratio B/A was measured when an area of a region in the observation region within a distance of 50 $\mu$m from a boundary between an active metal carbonized layer and the Mg solid solution layer toward the copper member was defined as A, and an area of the Cu-Mg intermetallic compound phase of a region in the observation region within a distance of 50 $\mu$m from a boundary between the active metal carbonized layer and the Mg solid solution layer toward the copper member was defined as B.

(Whether or Not Active Metal Compound Phase is Present)

The bonding interface between the copper plate and the carbon plate in the cross section of the obtained bonded body in the laminating direction was observed under conditions of a magnification of 2,000 times and an accelerating voltage of 15 kV using an electron beam microanalyzer (JXA-8539F manufactured by JEOL Ltd.), and elemental mapping of the active metal in a region including the bonding interface (400 $\mu$m × 600 $\mu$m) was obtained. Confirmation was made as to whether or not the active metal compound phase was present in a region, as a Cu-active intermetallic compound phase, satisfying a Cu concentration of 5 atom% or more and an active metal concentration of 16 atoms or more and 70 atom% or less from a 5-point average of quantitative analysis in the region confirmed by the presence of the active metal. The concentration here is a concentration when a total amount of Cu and the active metal is 100 atom%.

(Whether or Not Mg Solid Solution Phase is Present)

A region (400 $\mu$m × 600 $\mu$m) including the bonding interface between the copper plate and the carbon plate in the cross section of the obtained bonded body in the laminating direction was observed under conditions of a magnification of 2,000 times and an accelerating voltage of 15 kV using an electron beam microanalyzer (JXA-8539F manufactured by JEOL Ltd.). Quantitative analysis was performed at intervals of 10 $\mu$m from a surface of the carbon plate toward the copper plate in a range of 10 points or more and 20 points or less according to a thickness of the copper plate, and confirmation was made as to whether or not the Mg solid solution phase was present in a region, as a Mg solid solution phase, having the Mg concentration of 0.01 atom% or more and 6.9 atom% or less.

2,000 times of a thermal cycle, where one cycle is 5 minutes at -40°C and 5 minutes at 150°C were then applied to the obtained bonded body in Inventive Examples 1 to 8 and Comparative Examples 1 to 3.

In addition, a load test in which heating at 500°C for 30 minutes and cooling to room temperature (25°C) were repeated 10 times in a vacuum atmosphere was performed on the obtained bonded body in Inventive Examples 11 to 19.

Thereafter, an initial bonding area and a non-bonding area between the carbon plate and the copper plate were measured for these assemblies using an ultrasonic flaw detector (FineSAT200 manufactured by Hitachi Power Solutions Co., Ltd.) to calculate a bonding ratio of the interface between the carbon plate and the copper plate from the following equation.

$$\text{(Bonding Ratio)} = [\{(\text{Initial Bonding Area})\text{-}(\text{Non-Bonding Area})\}/(\text{Initial Bonding Area})] \times 100$$

The initial bonding area here means an area of a part to be bonded. Further, the non-bonding area means an area of a part that is not actually bonded, that is, an area of a part that is peeled off, among parts to be bonded. Since the peeling was indicated by a white part in the bonded part in an image obtained by binarizing an ultrasonic flaw detection image, an area of the white part was defined as a non-bonding area (peeling area).

[Table 1]

| | Mg And Active Metal Disposing Step | | | Bonding Step | | | Whether or Not Active Metal Carbide Layer was Present | Whether or Not Cu-Mg Intermetallic Compound Phase was Present | Whether or Not Active Metal Compound Phase was Present | Whether or Not Mg Solid Solution Layer was Present | Bonding Ratio (%) | |
| --- | --- | --- | --- | --- | --- | --- | --- | --- | --- | --- | --- | --- |
| | Amount of Mg $\mu$mol/cm$^2$ | Active Metal | | Load MPa | Holding Temperature °C | Holding Time min | | | | | Initial | After Loading Thermal cycle |
| | | Element | $\mu$mol/cm$^2$ | | | | | | | | | |
| Inventive Example 1 | 178.8 | Nb | 47.0 | 0.49 | 850 | 30 | Present | Present | Present | Present | 97.8 | 90.0 |
| Inventive Example 2 | 57.2 | Ti | 9.4 | 1.96 | 700 | 60 | Present | Present | Present | Present | 96.7 | 92.9 |
| Inventive Example 3 | 28.6 | Ti | 3.7 | 0.049 | 750 | 120 | Present | Absent | Absent | Present | 97.1 | 92.8 |
| Inventive Example 4 | 28.6 | Zr | 0.4 | 0.49 | 750 | 120 | Present | Absent | Absent | Present | 99.5 | 93.1 |
| Inventive Example 5 | 35.8 | Ti | 22.1 | 0.49 | 800 | 150 | Present | Absent | Present | Present | 99.3 | 96.7 |
| Inventive Example 6 | 35.8 | Zr | 29.2 | 1.47 | 900 | 30 | Present | Present | Present | Present | 96.4 | 95.0 |
| Inventive Example 7 | 14.3 | Nb | 20.7 | 0.49 | 850 | 90 | Present | Absent | Present | Present | 96.0 | 95.5 |
| Inventive Example 8 | 143.0 | Hf | 13.3 | 0.98 | 950 | 180 | Present | Absent | Present | Present | 97.5 | 94.7 |
| Comparative Example 1 | 5.7 | Ti | 22.1 | 0.49 | 800 | 150 | Absent | Absent | Present | Present | 39.9 | 0.0 |
| Comparative Example 2 | 35.8 | Zr | 0.1 | 1.47 | 900 | 30 | Absent | Present | Absent | Present | 54.5 | 0.0 |
| Comparative Example 3 | 5.7 | Hf | 0.1 | 0.98 | 950 | 180 | Absent | Absent | Absent | Present | 38.0 | 0.0 |

[Table 2]

| | Mg And Active Metal Disposing Step | | | Bonding Step | | | Whether or Not Active Metal Carbide Layer Is Present | Whether or Not Mg Solid Solution Layer Is present | Cu-Mg Intermetallic Compound Phase | | Whether or Not Active Metal Compound Phase Is Present | Bonding Ratio (%) | |
| | Amount | Active Metal | | Load MPa | Holding Temperature °C | Holding Time min | | | Present or Absent | Area Ratio B/A | | Initial | After Furnace Passage Test |
| | Amount of Mg $\mu$mol/cm$^2$ | Element | $\mu$mol/cm$^2$ | | | | | | | | | | |
| Inventive Example 11 | 57.2 | Ti | 9.4 | 1.96 | 700 | 10 | Present | Present | Present | 0.248 | Present | 96.1 | 91.1 |
| Inventive Example 12 | 57.2 | Ti | 9.4 | 1.96 | 700 | 60 | Present | Present | Present | 0.150 | Present | 97.0 | 93.2 |
| Inventive Example 13 | 57.2 | Ti | 9.4 | 1.96 | 700 | 90 | Present | Present | Present | 0.118 | Present | 97.1 | 94.4 |
| Inventive Example 14 | 28.6 | Zr | 0.4 | 0.49 | 700 | 120 | Present | Present | Present | 0.135 | Absent | 97.7 | 93.5 |
| Inventive Example 15 | 28.6 | Zr | 0.4 | 0.49 | 720 | 120 | Present | Present | Present | 0.094 | Absent | 98.1 | 94.5 |
| Inventive Example 16 | 28.6 | Zr | 0.4 | 0.49 | 750 | 120 | Present | Present | Absent | 0.000 | Absent | 97.6 | 95.0 |
| Inventive Example 17 | 143.0 | Hf | 13.3 | 0.98 | 720 | 180 | Present | Present | Present | 0.297 | Present | 96.2 | 88.5 |
| Inventive Example 18 | 143.0 | Hf | 13.3 | 0.98 | 830 | 180 | Present | Present | Present | 0.042 | Present | 96.7 | 94.6 |
| Inventive Example 19 | 143.0 | Hf | 13.3 | 0.98 | 950 | 180 | Present | Present | Absent | 0.000 | Present | 97.4 | 94.5 |

The copper-graphene bonded body in Comparative Examples 1 to 3 did not include the active metal carbide layer at a bonded part. Therefore, the bonding ratio between the copper plate and the carbon plate showed a low value of less than 60% at the initial stage, and was about 0 after loading the thermal cycle, such that it was found that the bonding was completely eliminated.

On the other hand, since the copper-graphene bonded body in Inventive Examples 1 to 8 and 11 to 19 included the active metal carbide layer at the bonded part, the bonding ratio between the copper plate and the carbon plate showed a high value over 95%, such that it was found that the bonding ratio did not fall below 90% even if the loading of the thermal cycle or a furnace passage test was performed in the same manner as in Comparative Examples 1 to 3. It was found from these results that the copper-graphene bonded body in Inventive Examples 1 to 8 and 11 to 19 had sufficient strength to prevent peeling during loading of a cooling cycle and realizes high reliability.

[Reference Signs List]

> 20: Insulation substrate (copper-graphene bonded body)
> 21: Copper plate (copper member)
> 25: Carbon plate (graphene-containing carbonaceous member)
> 40: Bonding interface
> 40a: Boundary surface
> 41: Active metal carbide layer
> 42: Mg solid solution layer

**Claims**

1. A copper-graphene bonded body comprising:

   a copper member formed of copper or a copper alloy; and
   a graphene-containing carbonaceous member containing a graphene aggregate,
   wherein the copper-graphene bonded body has a structure in which the copper member and the graphene-containing carbonaceous member are bonded,
   between the copper member and the graphene-containing carbonaceous member, an active metal carbide layer containing a carbide of one or more kinds of active metal selected from Ti, Zr, Nb, and Hf is formed on a side of the graphene-containing carbonaceous member, and
   a Mg solid solution layer having Mg dissolved in a matrix phase of Cu is formed between the active metal carbide layer and the copper member.

2. The copper-graphene bonded body according to Claim 1,
   wherein a Cu-Mg intermetallic compound phase formed of an intermetallic compound containing Cu and Mg is present in the Mg solid solution layer.

3. The ceramic-copper-graphene bonded body according to Claim 2,
   wherein an area ratio B/A is 0.3 or less, where A is an area of a region in the Mg solid solution layer within a distance of 50 $\mu$m from a boundary between the active metal carbonized layer and the Mg solid solution layer toward the copper member, and B is an area of the Cu-Mg intermetallic compound phase.

4. The copper-graphene bonded body according to any one of Claims 1 to 3,
   wherein an active metal compound phase formed of an intermetallic compound containing Cu and the active metal is present in the Mg solid solution layer.

5. The copper-graphene bonded body according to any one of Claims 1 to 4,

   wherein the graphene-containing carbonaceous member contains a graphene aggregate formed by deposition of a single layer or multiple layers of graphene, and flat graphite particles,
   the flat graphite particles are laminated with the graphene aggregate as a binder so that basal surfaces of the flat graphite particles overlap with one another, and
   the basal surfaces of the flat graphite particles are oriented in one direction.

6. A method for manufacturing the copper-graphene bonded body according to any one of Claims 1 to 5, the method comprising:

an active metal- and Mg-disposing step of disposing one or more kinds of active metal selected from Ti, Zr, Nb, and Hf, and Mg between the copper member and the graphene-containing carbonaceous member;

a laminating step of laminating the copper member and the graphene-containing carbonaceous member via the active metal and Mg; and

a bonding step of bonding the copper member and the graphene-containing carbonaceous member laminated via the active metal and Mg by being heat-treated in a vacuum atmosphere, while pressurizing the copper member and the graphene-containing carbonaceous member in a laminating direction,

wherein in the active metal- and Mg-disposing step, an amount of the active metal is set within a range of 0.4 $\mu$mol/cm$^2$ or more and 47.0 $\mu$mol/cm$^2$ or less, and an amount of Mg is set within a range of 14 $\mu$mol/cm$^2$ or more and 180 $\mu$mol/cm$^2$ or less.

7. The method for manufacturing a copper-graphene bonded body according to Claim 6,

wherein a pressurizing load in the bonding step is set within a range of 0.049 MPa or more and 1.96 MPa or less, and

a heating temperature in the bonding step is set within a range of 700°C or higher and 950°C or lower.

8. A copper-graphene bonded structure comprising:

a structure in which a copper member formed of copper or a copper alloy and a graphene-containing carbonaceous member containing a graphene aggregate are bonded,

wherein between the copper member and the graphene-containing carbonaceous member, an active metal carbide layer containing a carbide of one or more kinds of active metal selected from Ti, Zr, Nb, and Hf is formed on a side of the graphene-containing carbonaceous member, and

a Mg solid solution layer having Mg dissolved in a matrix phase of Cu is formed between the active metal carbide layer and the copper member.

# FIG. 1

# FIG. 2

FIG. 3

FIG. 4

```
┌─────────────────────────────────┐
│    CARBON PLATE FORMING STEP    │
└─────────────────────────────────┘
                 │
                 ▼
┌─────────────────────────────────┐
│        ACTIVE METAL AND         │
│      Mg DISPOSING STEP          │
└─────────────────────────────────┘
                 │
                 ▼
┌─────────────────────────────────┐
│        LAMINATING STEP          │
└─────────────────────────────────┘
                 │
                 ▼
┌─────────────────────────────────┐
│         JOINING STEP            │
└─────────────────────────────────┘
                 │
                 ▼
╭─────────────────────────────────╮
│      INSULATION SUBSTRATE        │
│  (COPPER/GRAPHENE JOINED BODY)   │
╰─────────────────────────────────╯
```

## INTERNATIONAL SEARCH REPORT

| International application No. |
| --- |
| PCT/JP2021/002260 |

### A. CLASSIFICATION OF SUBJECT MATTER

H01L 23/36(2006.01)i; H01L 23/373(2006.01)i; C04B 37/02(2006.01)i; C01B 32/194(2017.01)i; C01B 32/914(2017.01)i; C01B 32/921(2017.01)i
FI: H01L23/36 M; C04B37/02 B; C01B32/921; C01B32/914; C01B32/194; H01L23/36 D

According to International Patent Classification (IPC) or to both national classification and IPC

### B. FIELDS SEARCHED

Minimum documentation searched (classification system followed by classification symbols)
H01L23/36; H01L23/373; C04B37/02; C01B32/194; C01B32/914; C01B32/921

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2015-532531 A (MOMENTIVE PERFORMANCE MATERIALS INC.) 09 November 2015 (2015-11-09) paragraphs [0022]-[0032], fig. 2 | 1–8 |
| A | JP 2019-096858 A (FUJITSU KASEI KK) 20 June 2019 (2019-06-20) paragraphs [0044]-[0056], fig. 4 | 1–8 |
| P, A | JP 2020-053613 A (MITSUBISHI MATERIALS CORP.) 02 April 2020 (2020-04-02) paragraphs [0014]-[0017], fig. 1-2 | 1–8 |
| P, A | JP 2020-188235 A (MITSUBISHI MATERIALS CORP.) 19 November 2020 (2020-11-19) paragraphs [0027]-[0033], fig. 1 | 1–8 |

☐ Further documents are listed in the continuation of Box C.　　☒ See patent family annex.

| | |
| --- | --- |
| *　Special categories of cited documents: | "T"　later document published after the international filing date or priority date and not in conflict with the application but cited to understand the principle or theory underlying the invention |
| "A"　document defining the general state of the art which is not considered to be of particular relevance | |
| "E"　earlier application or patent but published on or after the international filing date | "X"　document of particular relevance; the claimed invention cannot be considered novel or cannot be considered to involve an inventive step when the document is taken alone |
| "L"　document which may throw doubts on priority claim(s) or which is cited to establish the publication date of another citation or other special reason (as specified) | "Y"　document of particular relevance; the claimed invention cannot be considered to involve an inventive step when the document is combined with one or more other such documents, such combination being obvious to a person skilled in the art |
| "O"　document referring to an oral disclosure, use, exhibition or other means | |
| "P"　document published prior to the international filing date but later than the priority date claimed | "&"　document member of the same patent family |

| Date of the actual completion of the international search | Date of mailing of the international search report |
| --- | --- |
| 31 March 2021 (31.03.2021) | 13 April 2021 (13.04.2021) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

INTERNATIONAL SEARCH REPORT

Information on patent family members

International application No.

PCT/JP2021/002260

| Patent Documents referred in the Report | Publication Date | Patent Family | Publication Date |
|---|---|---|---|
| JP 2015-532531 A | 09 Nov.2015 | US 2015/0253089 A1 paragraphs [0021]-[0031], fig. 2 WO 2014/052282 A1 EP 2901826 A1 CN 104813751 A | |
| JP 2019-096858 A | 20 Jun. 2019 | WO 2019/098377 A1 CN 111356544 A | |
| JP 2020-053613 A | 02 Apr. 2020 | (Family: none) | |
| JP 2020-188235 A | 19 Nov. 2020 | (Family: none) | |

Form PCT/ISA/210 (patent family annex) (January 2015)

**EP 4 095 896 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020009691 A
- JP 2021007345 A
- JP 2012238733 A